**Europäisches Patentamt**

(19) **European Patent Office**

**Office européen des brevets**

(11) Veröffentlichungsnummer: **0 048 935**
**B2**

(12) # NEUE EUROPÄISCHE PATENTSCHRIFT

(45) Veröffentlichungstag der neuen Patentschrifft:
28.02.90

(21) Anmeldenummer: 81107530.8

(22) Anmeldetag: 22.09.81

(51) Int. Cl. ⁵: **H 03 L  7/00,** G 01 S  7/28,
**G 01 S  13/22,** H 03 K  3/01

(54) Schaltungsanordnung zum phasenrichtigen Starten eines quarzgesteuerten Taktoszillators.

(30) Priorität: 29.09.80 DE 3036712

(43) Veröffentlichungstag der Anmeldung:
07.04.82 Patentblatt 82/14

(45) Bekanntmachung des Hinweises auf die Patenterteilung:
26.09.84 Patentblatt 84/39

(45) Bekanntmachung des Hinweises auf die Entscheidung
über den Einspruch:
28.02.90 Patentblatt 90/09

㊷84 Bennante Vertragsstaaten:
BE CH FR GB IT LI NL

(56) Entgegenhaltungen:
DE-A-1 954 402
DE-A-2 217 967
DE-A-2 407 090
DE-A-2 443 248
DE-A-2 812 158
DE-A-2 911 450
DE-B-1 176 724
DE-B-1 950 684
DE-B-1 950 686
DE-B-2 152 595
DE-B-2 202 581

(73) Patentinhaber: **Siemens Aktiengesellschaft**
**Wittelsbacherplatz 2**
**D-8000 München 2 (DE)**

(72) Erfinder: **Fischer, Georg, Ing. Grad.**
**Willi-Graf-Strasse 25 Zimmer 389**
**D-8000 München 40 (DE)**
Erfinder: **Peters, Rainer, Dipl.-Ing.**
**Goerdelerstrasse 12**
**D-8025 Unterhaching (DE)**

EP 0 048 935 B2

## Beschreibung

Die Erfindung bezieht sich auf eine Schaltungsanordnung zum phasenrichtigen Starten eines quarzgesteuerten Taktoszillators, bei Sendeimpulsen veränderbarer Pulsfolgefrequenz (PRF) in Radargeräten.

In Radarsendern mit sich laufend ändernder Impulsfolgefrequenz (PFR) und mit gepulsten, selbstschwingenden Senderendstufen ist der Entfernungstortakt (Abtast-Takt des empfangenen Signals) in Bezug auf die Einhüllende des Sendeimpulses bei durchlaufendem Taktoszillator stark verjittert.

Dadurch wird es notwendig, den Entfernungstortakt auf die Flanken des Sendeimpulses jedesmal neu auszurichten, da die Festzeichenunterdrückung im Radarempfänger von der exakten Abtastung der empfangenen Echosignale abhängt.

Hierzu wird von der Anstiegsflanke des Sendeimpulses ein Triggerimpuls hergeleitet, mit dem der Taktoszillator phasenstarr synchronisiert werden muß. Da die Phasenreferenz (Triggerimpuls) nur aus einem einzigen Puls besteht, ist eine phasenstarre Synchronisation des Taktoszillators über Phase Locked Loops nicht möglich.

Bisher hat man sich mit Taktoszillatoren mit geringen Resonatorgüten beholfen, die mit jedem Triggerimpuls neu gestartet und nach dem Ende der Empfängerperiode gestoppt wurden. Durch die geringen Resonatorgüten war es möglich, den Oszillator einigermaßen phasenrichtig zu starten. Der Ausgang eines NAND-Gatters wurde über eine Verzögerungsleitung (Resonator) auf einen Gattereingang zurückgekoppelt. Mit dem zweiten Gattereingang wurde die Schaltung aktiviert (Start) bzw. außer Betrieb gesetzt (Stop).

Hohe Ungenauigkeit der Taktfrequenz und großer Temperaturgang, bedingt durch die Eigenschaften der Verzögerungsleitung, waren die Folge.

Der Erfindung liegt die Aufgabe zugrunde, für eine Schaltungsanordnung der eingangs genennten Art eine Schaltung anzugeben, die es ermöglicht, den Hochfrequenzoszillator durch einen Triggerpuls phasenrichtig zu starten.

Gemäß der Erfindung wird diese Aufgabe dadurch gelöst, daß eine quarzgesteuerte Oszillatorschwingung in einer Frequenzvervielfacher-Stufe auf ein ganzzahliges Vielfaches der Entfernungstortaktfrequenz angehoben, in einer nachfolgenden rücksetzbaren Frequenzteilerschaltung auf die Sendefrequenz heruntergeteilt und der Teilungsvorgang auf den Triggerpuls synchronisiert wird.

Durch diese Schaltungsmaßnahmen ist das Ausgangssignal (Entfernungstortakt) bis auf einen kleinen Restjitter phasenstarr an den Triggerimpuls gekoppelt. Der Restjitter ($t_j$) wird um so kleiner, je höher die Frequenz ($f_{max}$) am Ausgang der Vervielfacher-Stufe gewählt ist. Die obere Grenze von ($f_{max}$) ist durch die maximale Clock-Frequenz der verfügbaren Teilerbausteine gegeben.

Die Erfindung und weitere Einzelheiten der Erfindung werden anhand der Figure 2 bis 3 näher erläutert.

Es zeigen

Figur 1 ein Impulsdiagramm mit Triggerpulsfolge und Sendefrequenz,
Figur 2 ein Blockschaltbild der Schaltungsanordnung zum phasenrichtigen Triggern,
Figur 3 ein Impulsdiagramm zur Erläuterung der Wirkungsweise dieser Schaltungsanordnung.

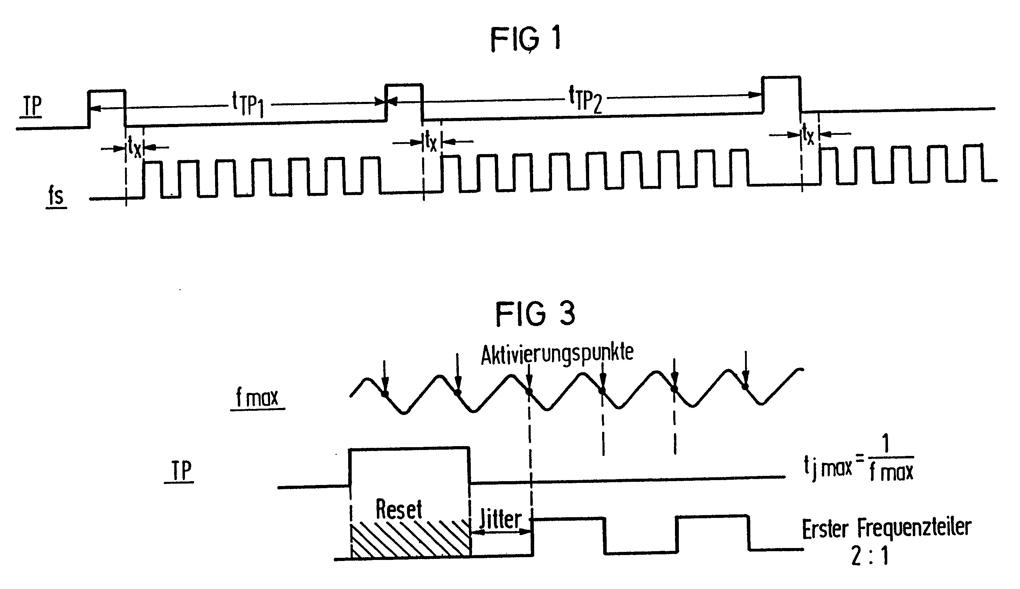

Anhand der beiden Impulszüge in Figur 1 wird verdeutlicht, welche Anforderung an einen jitterarmen Start-Stop-Oszillator gestellt wird. Das quarzstabile Signal $f_s$ (Entfernungstortaktfrequenz) soll von einem Triggerpuls TP phasenrichtig gestartet werden können. Dabei darf keine Periodizität der Triggerpulse vorausgesetzt werden ($t_{TP1} \neq t_{TP2}$). Die quarzstabile Schwingung fs muß zwischen zwei Triggerpulsen kohärent zum auslösenden Triggerpuls sein. Im Idealfall der phasenstarren Kopplung zwischen Triggerpuls TP und Schwingung fs ist die Zeit $t_x$ zwischen Startbefehl und Nulldurchgang des Signals konstant.

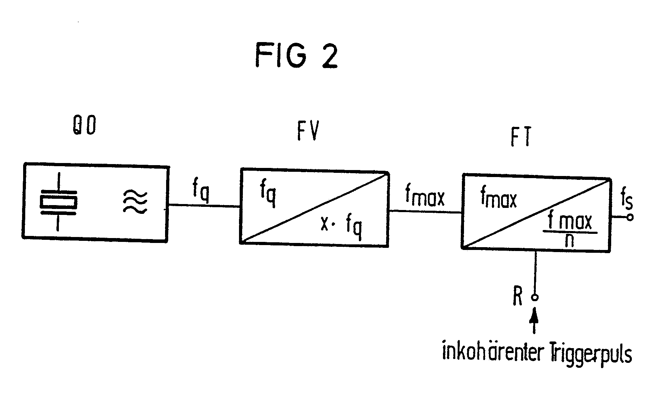

Ein Ausführungsbeispiel für die Durchführung einer jitterarmen Anbindung von Triggerpuls und Schwingung enthält nach Figur 2 einen Quarzoszillator QO, einen Frequenzvervielfacher FV und einen Frequenzteiler FT mit Rücksetzmöglichkeit. Um die angestrebte hohe Frequenzstabilität zu erreichen, wird das triggerbare Signal $f_s$ (Sendefrequenz) aus einem Vielfachen der quarzkontrollierten Schwingung $f_q$ abgeleitet. Der Quarzoszillator QO bekannter Ausführung erzeugt das Signal der Frequenz $f_q$ das im Frequenzvervielfacher FV auf den Wert $x \cdot f_{max}$ vervielfacht wird.

Im Frequenzteiler FT wird schließlich die Frequenz $f_{max}$ auf die gewünschte Sendefrequenz $f_s$ heruntergeteilt. Für den Synchronisiervorgang ist vorausgesetzt, daß der Frequenzteiler FT über einen besonderen Eingang R setzbar oder rücksetzbar ist. Derartige Frequenzteiler sind bekannt. Bei Anliegen eines Triggerpulses TP am Rücksetzeingang R setzt mit dem ersten Nulldurchgang der Frequenz $f_{max}$ die Frequenzteilung in der ersten von mehreren Stufen des Frequenzteilers (Flip-Flop) Aktivierungspunkte des ersten Frequenzteilers dar. Die Sendefrequenz $f_s$ ist dann bis auf einen kleinen Restjitter phasenstarr an den Trigger gekoppelt.

Wenn in einem Radarsystem ein maximaler Jitter von z. B. 2ns zwischen Triggerpuls TP und Sendefrequenz $f_s$ zugelassen werden darf, ergibt sich folgendes Zahlenbeispiel:

$f_q = 100$ Mhz
$x = 6$
$f_{max} = x \cdot f_q = 600$ Mhz
$t_j = 1/f_{max} = 1,67$ ns
$n = 100$
$f_s = f_{max}/n = 6$ Mhz

Die mit der Schaltung gemäß der Erfindung erzielbaren geringen Jitterwerte führen zur einer Verbesserung der Festzeichenunterdrückung, sowie zu einer wesentlichen Verbesserung der Entfernungsbestimmung in einem Radarempfänger.

**Patentansprüche**

1. Schaltungsanordnung zum phasenrichtigen Triggern eines quarzgesteuerten Taktoszillators bei Sendeimpulsen veränderbarer Pulsfolgefrequenz (PRF) in Radargeräten, dadurch gekennzeichnet, daß eine quarzgesteuerte Oszillatorschwingung ($F_q$) in einer Frequenzvervielfacher-Stufe (FV) auf ein ganzzahliges Vielfaches der zu triggernden Entfernungstortaktfrequenz ($f_s$) angehoben und in einer nachfolgenden rücksetzbaren Frequenzteilerschaltung (FT) auf die Entfernungstortaktfrequenz ($f_s$) heruntergeteilt ist, wobei der Teilungsvorgang auf den Triggerpuls synchronisiert ist.

2. Schaltungsanordnung nach Anspruch 1, dadurch gekennzeichnet, daß die Synchronisation der Oszillatorfrequenz ($f_s$) auf den Triggerpuls (TP) durch Setzen bzw. Rücksetzen des Teilers mit Triggerpuls (TP) erfolgt.

**Claims**

1. A circuit arrangement for the in-phase triggering of a quartz-controlled clock pulse oscillator, for transmitting pulses of variable pulse train frequency (PRF) in radar devices, *characterised in that* in a frequency multiplier stage (FV) a quarts-controlled oscillation ($F_q$) is raised to an integral multiple of the range gate clock pulse frequency ($f_s$) which is to be trigged and in a following frequency divider circuit (FT), which can be reset, divided to the range gate clock pulse frequency ($f_s$), the dividing process being synchronised by the trigger pulse.

2. A circuit arrangement as claimed in Claim 1, *characterised in that* the synchronisation of the oscillator frequency ($f_s$) by the pulse (TP) is effected by trigger pulse (TP) setting or resetting of the driver.

**Revendications**

1. Montage pour déclencher, de façon correcte du point de vue de la phase, un oscillateur de cadence piloté par quartz, dans le cas d'impulsions d'émission possédant une fréquence de récurrence (PRF) variable dans des appareils de radar, caractérisé par le fait qu'une oscillation ($F_q$) de l'oscillateur piloté par quartz est accrue, dans un étage multiplicateur de fréquence (FV), à un multiple entier de la fréquence d'horloge ($f_s$) de la porte de distance, devant être déclenchée, et est réduite par division dans un circuit diviseur de fréquence (FT) pouvant être ramené à zéro, monté en aval, à la fréquence d'horloge ($f_s$) de la porte de distan le processus de division étant synchronisé sur l'impulsion de déclenchement.

2. Montage suivant la revendication 1, caractérisé par le fait que la synchronisation de la fréquence de l'oscillateur ($f_s$) sur l'impulsion de déclenchement (TP) est réalisée par positionnement ou remise à zéro du diviseur par l'impulsion de déclenchement (TP).

## FIG 1

TP

$t_{TP_1}$    $t_{TP_2}$

$t_x$    $t_x$    $t_x$

fs

## FIG 3

Aktivierungspunkte

f max

TP    $t_{j\,max} = \dfrac{1}{f\,max}$

Reset    Jitter    Erster Frequenzteiler
2 : 1

EP 0 048 935 B2

# FIG 2

inkohärenter Triggerpuls